# EUROPEAN PATENT APPLICATION

(11) **EP 2 937 205 A1**
(43) Date of publication of application: **28.10.2015**
(21) Application number: 15001223.5
(22) Date of filing: 24.04.2015
(51) Int. Cl.: B29C 63/02

(54) **STABILIZATION DEVICE USED TO INSTALL A PROTECTIVE FILM ON AN LCD SCREEN OF A CELL PHONE**

(30) Priority: 25.04.2014 CN 201420208045 U
(71) Applicant: Towarzystwo Gospodarcze LAMEL Andrzej Leszczynski, 66-400 Gorzow Wielkopolski (PL)
(72) Inventor: Wang, Yukun, Guangzhou (CN)
(74) Representative: Zielinski, Wojciech Leszek

(57) **Abstract**

The utility model presents the device to stabilize the process of installation of a protective film on an LCD screen of a cell phone. Its characteristic feature is that it is composed mainly of the bar-shaped fixing block (1), USB connectors, located on the fixing block (1), adjusted to fit USB ports (2), and pins (3), which also are placed on the fixing block (1) and their arrangement and number corresponds to installation cut-outs of a protective film. The object of the utility model allows for a quick and precise installation of a protective film on an LCD screen of a cell phone and thereby it eliminates the necessity to have an expert install the protective film.

## Description

The object of the utility model is the device that stabilizes installation (facilitates application) of a film, and more specifically the type of stabilization device to install a protective film on an LCD screen of a cell phone.

At the moment, cell phone is the most commonly used mean of communication used by people. In order to protect an LCD screen of a cell phone against scratches, users are willing to apply a protective film on screens of their phones. In order to avoid misplacing of a film during installation, the process of securing an LCD screen with a protective film is often entrusted to an expert. A regular user is unable to properly install or replace a film on an LCD of a cell phone by him or herself.

The purpose of the utility model is to eliminate the problem related to the necessity to have an expert protect an LCD screen of a cell phone with a protective film, since a regular user is unable to properly install or replace it by him or herself, and this is the purpose, the stabilization device to install a protective film on an LCD screen of a cell phone is supposed to serve.

Therefore, the technical solutions applied in the utility model are as follows: the stabilization device to install a protective film on an LCD screen of a cell phone is composed mainly of the fixing block, USB connectors, compatible with USB ports of a cell phone, placed on the fixing block and pins, also placed on the fixing block, the number and arrangement of which corresponds to installation cut-outs in a protective film.

Furthermore, the aforementioned USB connectors, two of them, are located on opposite sides of the fixing block and there are at least two of the aforementioned pins.

In order to reduce the weight of the item, the internal part of the aforementioned fixing block is empty.

In comparison to other technical solution, the object of the utility model holds the following advantages:
1. the entire structure of the utility model is very simple and its use as well as production are not complicated.
2. the object of the utility model allows for a quick and precise installation of a protective film on an LCD screen of a cell phone and thereby it eliminates the necessity to have an expert install the protective film.

The subject of the invention is presented in exemplary embodiments in drawings on which: Figure 1 shows the three-dimensional view of the object of the utility model; Figure 2 shows the main view, the front of the object of the utility model; Figure 3 shows the top view of the object of the utility model, and Figure 4 shows the back view of the object of the utility model. Symbols and names included in figures:
1. fixing block,
2. USB connectors,
3. pins,
4. technological stiffener.

Examples of specific realizations presented below constitute the further part of the detailed description of the object of the utility model and are not limited to the following.

### Examples of realization

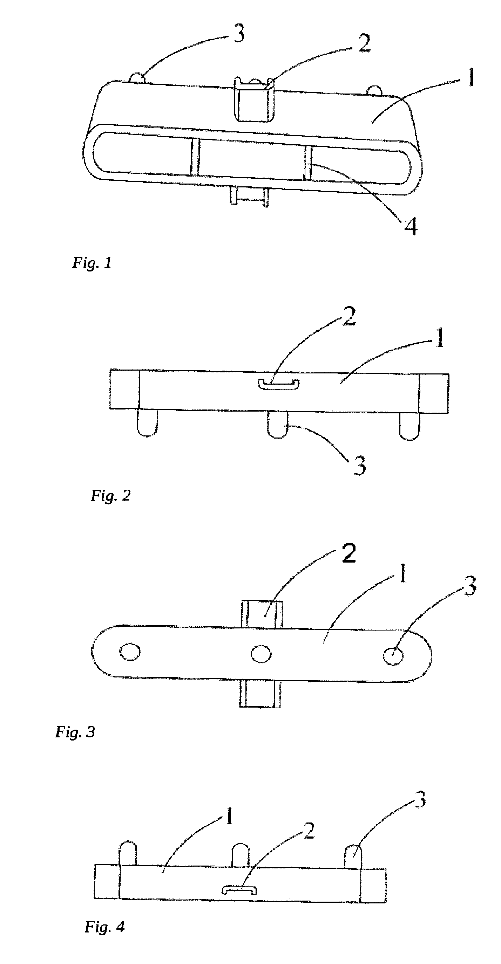

Object of the utility model - stabilization device, as presented in figures 1-4, is composed of three elements: the fixing block 1, USB connectors 2 and pins 3. The described fixing block 1 is made in the shape of a plastic or metal bar. Furthermore, in order to reduce the weight of the entire stabilization device, the object of the utility model purposefully utilizes a structure with an empty space inside of the fixing block 1. At the same time, the technological stiffener 4 is used inside of the empty space of the fixing block 1, in order to make it rigid and resistant to squeezing.

The shape of USB connectors 2, placed on sides of the fixing block 1 must correspond to USB ports in a cell phone, in order to guarantee that while using the object of the utility model, USB connector will enter into USB ports of a cell phone and the entire stabilization device will be connected to a cell phone. It is possible to produce the object only with 1 USB connector 2 or with 2 USB connectors 2. In the case, there is only 1 USB connector 2, it can only be a connector that is compatible with the USB port of a cell phone. In the case, there are 2 USB connectors 2, depending on conditions, connectors can be made to fit only 1 type of the USB port or each can be different, corresponding to 1 type of the USB port.

Pins 3 are located on sides of the fixing block 1 and their shape, quantity and arrangement should correspond to the shape, quantity and arrangement of installation cut-outs of a protective film for a cell phone. At least two pins are required to ensure that the film does not relocate itself during the process of installation.

When using the object, it is necessary to first put the USB connector 2, placed on the fixing block 1, to the USB port of a cell phone, afterwards installation cut-outs of a screen protector must be placed on appropriate pins 3 and in the end the remaining, unnecessary auxiliary layer can be removed, exposing the actual protective film.

## Claims

1. The device used to stabilize the process of installation of a protective film on an LCD screen of a cell phone. It is composed mainly of the fixing block, shaped as a bar (1), USB connectors (2), placed on the fixing block (1), adjusted to fit USB ports of a cell phone, and pins located on the fixing block (1), the number and arrangement of which corresponds to installation cut-outs in a protective film.

2. The characteristic feature of the stabilization device to install protective films on an LCD screen of a cell phone, as described in (item) 1 of the application for protection rights, are 2 aforementioned USB connectors (2) located on opposite sides of the fixing block (1).

3. The characteristic feature of the stabilization device to install protective films on an LCD screen of a cell phone, as described in (item) 1 or (item) 2 of the application for protection rights, are at least 2 of the aforementioned pins (3).

4. The characteristic feature of the stabilization device to install protective films on an LCD screen of a cell phone, as described in (item) 3 of the application for protection rights, is the structure with an empty space inside of the aforementioned fixing block (1).
